# EUROPEAN PATENT APPLICATION

(11) **EP 2 908 339 A1**
(43) Date of publication of application: **19.08.2015**
(21) Application number: 14155438.6
(22) Date of filing: 17.02.2014
(51) Int. Cl.: H01L 25/07, H03K 17/0412, H03K 17/06, H02H 3/08

(54) **Power semiconductor arrangement and method for protecting a power semiconductor module against failures**

(71) Applicant: ABB Technology AG, 8050 Zürich (CH)
(72) Inventor: Bianda, Enea, 5400 Baden (CH); Heinemann, Alexander, 5417 Untersiggenthal (CH); Lüthi, Christian, 5212 Hausen (CH); Knapp, Gerold, 5420 Ehrendingen (CH); Vemulapati, Umamaheswara, 5430 Wettingen (CH)
(74) Representative: ABB Patent Attorneys

(57) **Abstract**

The invention relates to a power semiconductor arrangement, comprising a power semiconductor module (1) and a control driving device (2), wherein the power semiconductor module (1) comprises a plurality of power semiconductor devices (3), a first main module contact (4), a first auxiliary contact (5), a second main module contact (6) and a control module contact (7), each power semiconductor device (3) comprises a first main device contact, a first auxiliary device contact, a second main device contact and a control device contact, whereby all first main device contacts are connected to the first main module contact (4), all first auxiliary device contacts are connected to the first auxiliary module contact (5), all second main device contacts are connected to the second main module contact (6), and all control main device contacts are connected to the control module contact (7), the control driving device (2) is configured for switching on the power semiconductor module (1) by applying a turn-on signal to the control module contact (7) and for switching off the power semiconductor module (1) by applying a turn-off signal to the control module contact (7).

## Description

### Technical Field

The invention relates to a power semiconductor arrangement, comprising a power semiconductor module and a control driving device, wherein the power semiconductor module comprises a plurality of power semiconductor devices, a first main module contact, a first auxiliary module contact, a second main module contact and a control module contact, and wherein each power semiconductor device comprises a first main device contact, a first auxiliary device contact, a second main device contact and a control device contact, whereby all first main device contacts are connected to the first main module contact, all first auxiliary device contacts are connected to the first auxiliary module contact, all second main device contacts are connected to the second main module contact, and all control main device contacts are connected to the control module contact. The invention furthermore relates to a method for protecting said power semiconductor module against failures.

### Background Art

Power semiconductor devices, such as insulated gate bipolar transistors (IGBT), reverse conductive insulated gate bipolar transistors (reverse conducting IGBT) and/or bi-mode insulated gate transistors (BIGT), are mostly used as a fast switching devices for very high electrical currents and voltages. The popularity of IGBTs is rising due to their excellent electrical properties and relatively easy driving. They are widely used in applications like electrical motor control equipment, e.g. for hybrid and electrical cars, locomotives, ship propulsions, industrial equipment, machineries etc., DC electrical transmission, such as DC-AC converters, wind and solar power converters and synchronizers, power network cosinus φ compensators, emergency power supplies etc.

Very often, a plurality of IGBT dies are connected in parallel encapsulated in a module to increase their switching capabilities. A problem that appears in such parallel connections is that a defect, for example, in a gate and especially a short circuit connection between a gate and an emitter makes all of the IGBT devices in the module uncontrollable. In particular, a failed IGBT module with a damaged IGBT device usually presents short-circuits between collector-emitter, gate-emitter and/or collector-gate terminals. More particularly, a short-circuit between gate-emitter prevents control of the IGBT with a conventional gate driver and therefore it is not possible to turn on the remaining good IGBT devices and redirect the current flow through the controllable IGBT devices.

The loss of control becomes critical when high short-circuit currents with a long duration are involved, for example in traction converters, since the current can only flow through the damaged IGBT device, which has, for example, a collector-emitter short-circuit. The damaged IGBT device overheats and vaporizes, and thus causes arcing that spread to the other IGBT devices of the IGBT module and eventually causes explosion. The explosion leads to an unwanted destruction not only of the failing part of the IGBT module but also of the neighbouring parts in the traction converter, which incurs high cost and time to repair the damage. The issue becomes more critical through the fact that the only known protection measure known from prior art to clear an IGBT fault - the desaturation detection and switch-OFF - will systematically fail in most cases and therefore is not able to avoid critical fault situations in the converter.

### Summary of invention

It is therefore an object of the invention to provide a power semiconductor arrangement and method for protecting a power semiconductor module against failures, such as overheating or explosion, in case at least one power semiconductor devices is damaged within the power semiconductor module comprising a plurality of power semiconductor devices.

The object of the invention is solved by the features of the independent claims. Advantageous embodiments are detailed in the dependent claims.

Thus, the object is solved by a power semiconductor arrangement comprising
a power semiconductor module and a control driving device, wherein the power semiconductor module comprises a plurality of power semiconductor devices, a first main module contact, a first auxiliary module contact, a second main module contact and a control module contact,
each power semiconductor device comprises a first main device contact, a first auxiliary device contact, a second main device contact and a control device contact, whereby all first main device contacts are connected to the first main module contact, all first auxiliary device contacts are connected to the first auxiliary module contact, all second main device contacts are connected to the second main module contact, and all control main device contacts are connected to the control module contact,
the control driving device is configured for switching on the power semiconductor module by applying the control module contact with a turn-on signal and for switching off the power semiconductor module by applying the control module contact with a turn-off signal, whereby the turn-on signal is greater than the turn-off signal,
the control driving device is further configured for checking if a first resistivity between the first main module contact and the control module contact, a second resistivity between the first main module contact and the second main module contact and/or a third resistivity between the control module contact and the second main module contact is below a threshold, and,
if the first, second and/or third resistivity is below the threshold, the control driving device is configured for switching the control module contact or the first auxiliary module contact into a disconnected state and/or the control driving device is configured for switching the control module contact with an overdrive signal greater than the turn-on signal.

A key point of the proposed solution is therefore to monitor respectively check if the resistivity between two contacts of the power semiconductor module respectively of a power semiconductor device falls below a defined threshold. Such case indicates that the power semiconductor module respectively at least one of the power semiconductor devices suffered a failure, which is usually characterised as a short-circuit between collector-emitter, gate-emitter and/or collector-gate terminals of the power semiconductor module respectively of at least one power semiconductor device within the module. Checking if the resistivity has fallen under a certain threshold, e.g. below a predefined threshold, can be done by measuring the respective resistivity by any suitable means known from prior art, whereby the threshold can be variable in terms of the power semiconductor module respectively power semiconductor device type.

If checking the resistivity has resulted in that the resistivity is below the threshold, a first measure is to switch a control driving impedance for driving the control module contact, or the first auxiliary module contact, to high by disconnecting said contact i.e. switching into the disconnected state. In other words, the control driving impedance of the control driving device, which in standard operation is connected to the control module contact, is set to a high state, an open state and/or a floating state. Such way the control voltage of the power semiconductor module respectively of the power semiconductor device is naturally regulated by the internal structure of the damaged power semiconductor device. As second alternative or parallel measure the control driving impedance for driving the control module contact is set to a low impedance, e.g. 0 Ohm, by applying the overdrive signal greater than the turn-on signal to the control module contact. Such way the control contact voltage, i.e. of the control module contact respectively of the control device contact can be maintained at the desired level as control contact current will constantly flow through the control module contact-first auxiliary module contact short of a damaged power semiconductor module. Instead of checking the first resistivity between the first main module contact and the control module contact also, in addition or as an alternative, the first resistivity between the first main auxiliary module contact and the control module contact could be checked. Further, instead of checking the second resistivity between the first main module contact and the second main module contact also, in addition or as an alternative, the second resistivity between first main auxiliary module contact and the second main module contact could be checked. Preferably, the turn-on signal and the turn-off signal are provided as a voltage, whereby the turn-on voltage is greater than the turn-off voltage.

With the proposed arrangement, the power semiconductor device protection can be achieved at the control contact driving device level, without requirement of bulky and expensive external hardware. The invention therefore proposes a cheap and non-invasive solution in order to protect a power semiconductor module from explosion. Hence, the availability of a converter connected to the power semiconductor module can be improved. In addition, servicing costs can also be reduced as the whole converter does not have to be replaced completely.

The power semiconductor module can be provided as so called StakPak module, manufactured by ABB and having, for example, a high power insulated gate bipolar transistor (IGBT) press-packs and diodes in an advanced modular housing that guarantees uniform chip pressure in multiple-device stacks. Preferably, the power semiconductor module and/or the power semiconductor devices is configured for switching "high currents", whereby this term should be understood as capable of transmitting, sharing, transforming and/or consuming currents of ≥ 1000 A, preferably of ≥ 5 kA and more preferably of ≥ 10 kA. The first auxiliary contact is preferably configured as a region on the semiconductor substrate of the power semiconductor device located between its first contact and second contact regions, as known to the man skilled in the art. More preferably, the first auxiliary contact is configured as auxiliary emitter and/or as a Kelvin connection/connection of Kelvin type to the first main contact of the power semiconductor module respectively to the power semiconductor device. The control driving device is preferably configured for driving the power semiconductor module, and thus all connected power semiconductor devices, by applying a turn-on signal of e.g. 15V to the control module contact for switching on the power semiconductor module, and thus all connected power semiconductor devices, and by applying a turn-off signal of e.g. -15V to the control module contact for switching off the power semiconductor module, and thus all connected power semiconductor devices.

The object is further solved by a power semiconductor arrangement comprising a power semiconductor module and a control driving device, wherein the power semiconductor module comprises a plurality of power semiconductor devices, a first main module contact, a second main module contact and a control module contact, each power semiconductor device comprises a first main device contact, a second main device contact and a control device contact, whereby all first main device contacts are connected to the first main module contact, all second main device contacts are connected to the second main module contact, and all control main device contacts are connected to the control module contact, the control driving device is configured for switching on the power semiconductor module by applying the control module contact with a turn-on signal and for switching off the power semiconductor module by applying the control module contact with a turn-off signal, whereby the turn-on signal is greater than the turn-off signal, the control driving device is further configured for checking if a first resistivity between the first main module contact and the control module contact, a second resistivity between the first main module contact and the second main module contact and/or a third resistivity between the control module contact and the second main module contact is below a threshold, and, if the first, second and/or third resistivity is below the threshold, the control driving device is configured for switching the control module contact into a disconnected state and/or the control driving device is configured for switching the control module contact with an overdrive signal greater than the turn-on signal. Thus, the power semiconductor module respectively the power semiconductor devices may also have not the auxiliary device contact installed i.e. only first and second main contact and control contact preferably configured for switching the first and second main contacts.

According to a preferred embodiment the control driving device comprises a low power switching device configured for switching the control module contact or the first auxiliary module contact into the disconnected state. More preferably, the low power switching device is a MOSFET device, for example a NMOS or a PMOS device. In another preferred embodiment the power semiconductor device is an IGBT, the first main contact of the power semiconductor device is an emitter of the IGBT, the first auxiliary contact of the power semiconductor device is an auxiliary emitter of the IGBT, the second main contact of the power semiconductor device is a collector of the IGBT and the control contact of the power semiconductor device is a gate of the IGBT. In an alternative embodiment the IGBT does not comprise an auxiliary emitter. Further preferably, the IGBT is provided as a reverse conducting IGBT or as a BIGT.

According to another preferred embodiment, the control driving device comprises a turn-on signal source configured for providing the turn-on signal and a turn-off signal source configured for providing the turn-off signal, the control driving device is adapted for checking if a fourth resistivity between the turn-on signal source and the control module contact and/or a fifth resistivity between the turn-off signal source and the control module contact is below the threshold value, and, if the fourth and/or fifth resistivity is below the threshold, the control driving device is configured for switching the control module contact or the first auxiliary module contact into the disconnected state and/or the control driving device is configured for switching the control module contact with the overdrive signal. Such way the fourth and/or fifth resistivity is preferably provided as a current sensing resistor on a turn-on respectively turn-off paths of the control driving device. According to another preferred embodiment the turn-off signal is ≥ -15V and ≤ -5V, the turn-on signal is ≥ 5V and ≤ 15V or ≤ 30V and/or the overdrive signal is ≥ 10V or ≥ 20V and ≤ 25V, ≤ 30V or ≤ 40V.

In a further preferred embodiment the power semiconductor module comprises 4, 8, 16, 24, 32, 64, 128, 256, 512 or any other amount of power semiconductor devices. Further preferred, the arrangement comprises a plurality of power semiconductor modules, whereby each power semiconductor module comprises its own control driving device. Alternatively, one single control driving device can be configured for switching all power semiconductor modules of the arrangement. Such embodiments allows for a very simple implementation of the invention.

The object is further solved by a power semiconductor arrangement comprising a power semiconductor module and a control driving device, wherein the power semiconductor module comprises a plurality of power semiconductor devices, a first main module contact, a second main module contact and a control module contact, each power semiconductor device comprises a first main device contact, a second main device contact and a control device contact, whereby all first main device contacts are connected to the first main module contact, all second main device contacts are connected to the second main module contact, and all control main device contacts are connected to the control module contact, the control driving device is configured for switching on the power semiconductor module by applying the control module contact with a turn-on signal and for switching off the power semiconductor module by applying the control module contact with a turn-off signal, whereby the turn-on signal is greater than the turn-off signal, the control driving device comprises a turn-on signal source configured for providing the turn-on signal and a turn-off signal source configured for providing the turn-off signal, the control driving device is adapted for checking if a fourth resistivity between the turn-on signal source and the control module contact and/or a fifth resistivity between the turn-off signal source and the control module contact is below the threshold value, and, if the fourth and/or fifth resistivity is below the threshold, the control driving device is configured for switching the control module contact or the first auxiliary module contact into the disconnected state and/or the control driving device is configured for switching the control module contact with the overdrive signal.

The object of the invention is further solved by a method for protecting a power semiconductor module against failures, wherein
the power semiconductor module comprises a plurality of power semiconductor devices, a first main module contact, a first auxiliary module contact, a second main module contact and a control module contact configured for switching on the power semiconductor module with a turn-on signal and for switching off the power semiconductor module with a turn-off signal,
each power semiconductor device comprises a first main device contact, a first auxiliary device contact, a second main device contact and a control device contact, whereby all first main device contacts are connected to the first main module contact, all first auxiliary device contacts are connected to the first auxiliary module contact, all second main device contacts are connected to the second main module contact, and all control main device contacts are connected to the control module contact, and
the method comprising the steps of:
checking if a first resistivity between the first main module contact and the control module contact, a second resistivity between the first main module contact and the second main module contact and/or a third resistivity between the control module contact and the second main module contact is below a threshold, and
if the first, second and/or third resistivity is below the threshold, switching the control module contact or the first auxiliary module contact into a disconnected state and/or switching the control module contact with an overdrive signal greater than the turn-on signal.

The method allows for controlling a damaged power semiconductor device respectively power semiconductor module in order to prevent the device respectively module from explosion. Thus, a damaged device respectively module can be protected from overheating and vaporizing, and therefore avoiding arcing and damage of other non-damaged devices and modules.

Method according to the previous claim, with a turn-on signal source configured for providing the turn-on signal and a turn-off signal source configured for providing the turn-off signal, wherein the method comprising the steps of:
checking if a fourth resistivity between the turn-on signal source and the control module contact and/or a fifth resistivity between the turn-off signal source and the control module contact is below the threshold value, and,
if the fourth and/or fifth resistivity is below the threshold value, switching the control module contact or the first auxiliary module contact into the disconnected state and/or switching the control module contact with the overdrive signal.
Preferably, the turn-off signal is ≥ -15V and ≤ -5V, the turn-on signal is ≥ 5V and ≤ 15V and/or the overdrive signal is ≥ 10V or ≥ 20V and ≤ 25V or ≤ 30V.

According to another preferred embodiment, the method comprises a low power switching device configured for switching the control module contact or the first auxiliary module contact into the disconnected state. More preferably, the low power switching device is a MOSFET device. In another embodiment the power semiconductor device is an IGBT, the first main contact of the power semiconductor device is an emitter of the IGBT, the first auxiliary contact of the power semiconductor device is an auxiliary emitter of the IGBT, the second main contact of the power semiconductor device is a collector of the IGBT and the control contact of the power semiconductor device is a gate of the IGBT. In a further preferred embodiment the power semiconductor module comprises 4, 8, 16, 24, 32, 64, 128, 256, 512 or any other amount of power semiconductor devices.

### Brief description of drawings

The invention will be described in more detail hereinafter with reference to examples of embodiments, to which the invention is not limited. In the following,
Fig. 1 shows a prior art power semiconductor module with desaturation switch off,
Fig. 2 shows the prior art power semiconductor module with formation of external short-circuit path,
Fig. 3 shows the prior art power semiconductor module with subsequent short-circuit,
Fig. 4 shows a preferred embodiment of the invention,
Fig. 5 shows an power semiconductor device according to the preferred embodiment of the invention,
Fig. 6 shows the preferred embodiment of the invention in a detailed view,
Fig. 7 shows another preferred embodiment of the invention in a detailed view,
Fig. 8 shows the preferred embodiment of the invention in a further detailed view,
Fig. 9 shows yet another preferred embodiment of the invention in a detailed view,
Fig. 10 shows the yet another preferred embodiment of the invention in a further detailed view, and
Fig. 11 shows a further another preferred embodiment of the invention in a detailed view.

### Description of embodiments

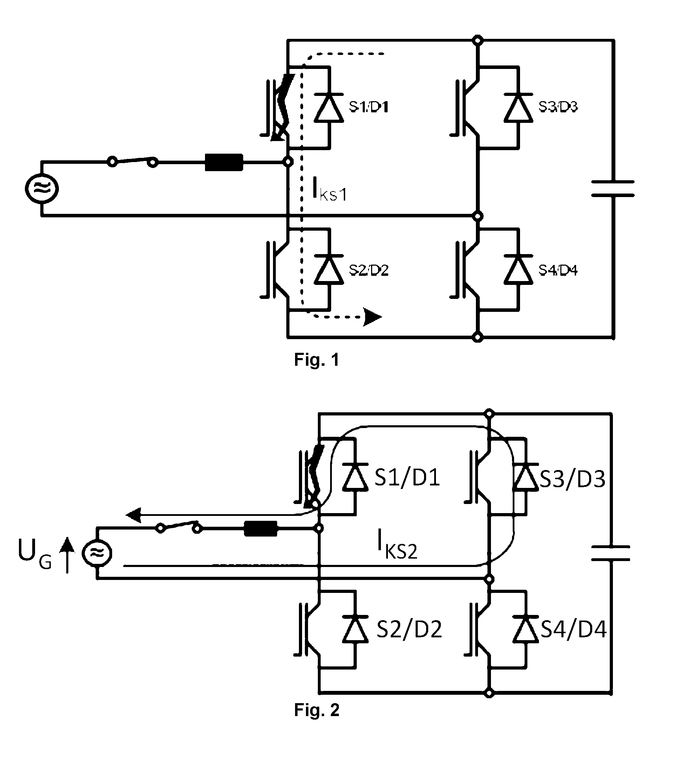

Fig. 1 to 3 show a prior art power semiconductor module with four IGBT power semiconductor devices. In Fig. 1, an initial fault is depicted as a loss of blocking capability of a single chip in the IGBT power semiconductor device switch S1, or diode D1. Cause for the loss of blocking capability can be a bulk defect in the silicon of the power semiconductor module due to a cosmic ray particle impact, a fault in an edge termination of the IGBT power semiconductor device or of the power semiconductor module, overvoltage or overheating. Only one IGBT power semiconductor device of the power semiconductor module is affected i.e. only IGBT power semiconductor device S1; the rest of the IGBT power semiconductor devices may remain in a fully operable condition in a first moment. Most probably, the fault occurs right after a switch-OFF action of S1 as the component stress is highest at this point.

As soon as IGBT power semiconductor device S2 is switching ON, for example as a consequence of the normal proceeding of the pulse pattern, a short-circuit path, depicted as dotted line Fig. 1, is opened through S1 and S2. Subsequently, S2, being the only operable switch in the path, desaturates and limits the short-circuit current to the physical limits of S2. The voltage over S2 rises to full DC-link voltage in spite of conducting the short-circuit current. A desaturation detection implemented in the gate drive of S2, not shown, detects the fault state and switches off S2 within about 10 µs. After that, the short circuit path is cleared and further damage to the converter is avoided. The short-circuit current loaded the faulty IGBT power semiconductor device switch of S1 and all IGBT power semiconductor device switches of S2 until desaturation switch-OFF, e.g. 10 µs of duration, which is not leading to excessive heating of any of these components.

After such first protection action, the feeding energy source to the power semiconductor module is still connected to shown phase system, depicted as inductance. The source can be a grid system or a motor, which is magnetized. Both cannot be disconnected from said faulty power semiconductor module system, as, e.g., a grid side main circuit breaker needs some 10-100 ms and a motor is demagnetized with the rotor time constant, which is also in the range of tens of milliseconds.

In one polarity of the feeding system, a slow short-circuit path then is opened, as shown in Fig. 2. In this example, if feeding voltage U_{G} is "negative", a short circuit current Iₖₛ₂, depicted as bold line, is flowing from source over diode D3 and the faulty single chip of S1 back into the source. The current is limited by transformer or motor stray inductance and may reach similar amplitudes as the desaturation short-circuit current Iₖₛ₁, but for a factor 1000 longer duration.

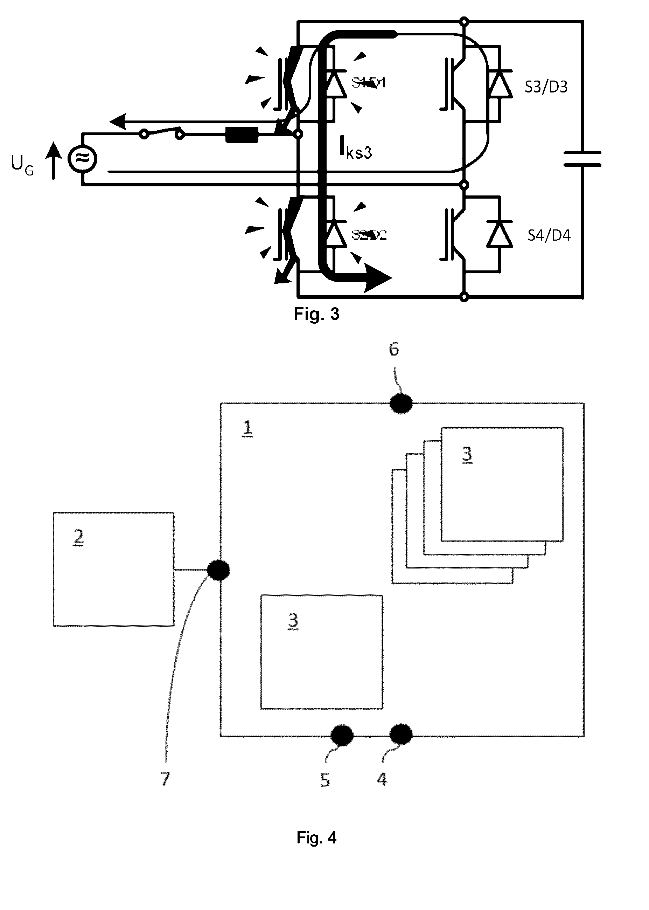

As a result of the current concentration of the faulty IGBT power semiconductor device chip S1 and/or its wirebonds, S1 overheats and vaporizes first, causing an arcing which rapidly spreads within S1/D1 and destroys all other IGBT power semiconductor device chips S2, S3 and/or S4 of the power semiconductor module. As a consequence, the arcing in switch S1 leads to high dv/dt or overvoltage stress of the blocking switch S2, which consequently may fail with loss of its blocking capability. An unlimited short-circuit current Iₖₛ₃ forms with amplitudes of several hundred kiloamperes, shown as bold thick line in Fig. 3, and leads to an explosion of the phase in said power semiconductor module. The degree of damage in the converter depends on the amount of DC-link capacitance in the converter and on the short circuit energy of the connected grid or motor.

Fig. 4 shows an exemplary embodiment of the invention comprising a power semiconductor module 1 and a control driving device 2. The power semiconductor module 1 comprises a plurality of power semiconductor devices 3, which are each provided as IGBTs. The power semiconductor module 1 comprises a first main module contact 4 being an emitter, a first auxiliary module contact 5 being an auxiliary emitter, a second main module contact 6 being a collector and a control module contact 7 being a gate.

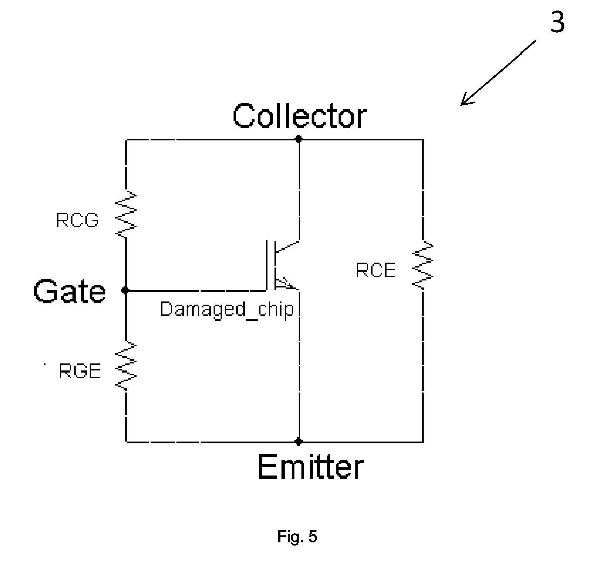

Each power semiconductor device 3 comprises a first main device contact provided as emitter, a first auxiliary device contact provided as auxiliary emitter, a second main device contact provided as collector and a control device contact provided as gate, as shown in Fig. 5, whereby of all power semiconductor devices 3 all first main device contacts are connected to the first main module contact 4, all first auxiliary device contacts are connected to the first auxiliary module contact 5, all second main device contacts are connected to the second main module contact 6, and all control main device contacts are connected to the control module contact 7, not shown. The first auxiliary module contact 5 respectively the first auxiliary device contact being the auxiliary emitter could be omitted in an alternative embodiment.

The control driving device 2 is configured for switching on the power semiconductor module 1 by applying the control module contact 7 with a turn-on signal, which is 15V, and for switching off the power semiconductor module 7 by applying the control module contact with a turn-off signal, which is -15V, such that the turn-on signal is greater than the turn-off signal. Thereby, as the gates of all power semiconductor devices 3 are connected to the control module contact 7, the control driving device 2 is therefore configured for switching on respectively off all power semiconductor devices 3.

For the following, it is assumed that the power semiconductor device 3 shown in Fig. 5 has a fault. The IGBT has short-circuit resistances between gate-emitter R_{GE} referred to as first resistance, between collector-emitter R_{CE} referred to as second resistance and between collector-gate R_{CG} referred to as third resistance. Capacitances are present as well between the collector, gate and emitter terminals in parallel to the before mentioned resistances, but at low frequency their impedance is very high, hence the before mentioned short-circuit resistances are dominant. When current flows through the IGBT there is a voltage drop V_{CE} between collector and emitter.

According to the invention, the control driving device 2 further is configured for checking respectively measuring if the first resistivity R_{GE} between the first main module contact 4 and the control module contact 6, a second resistivity R_{CE} between the first main module contact 4 and the second main module contact 7 and/or a third resistivity R_{CG} between the control module contact 7 and the second main module contact 6 is below a threshold. In such case i.e. if the first resistivity R_{GE}, the second resistivity R_{CE} and/or the third resistivity R_{CG} is below the threshold, the control driving device 2 is configured for switching the control module contact 7 or the first auxiliary module contact 5 into a disconnected state and/or the control driving device 2 is configured for switching the control module contact 7 with an overdrive signal greater than the turn-on signal.

In particular, for the first alternative, if the gate of the IGBT 3 is left floating a voltage V_{GE} drops between gate and emitter due to the presence of a voltage divider of R_{CG} and R_{GE} between collector and emitter, as per following equation: V_{GE} = (V_{CE}*R_{GE}) / (R_{CG}⁺R_{GE})

Initially i.e. when the fault starts to occur, current flows through the damaged IGBT 3. Then, as soon as V_{CE} is large enough to have a gate voltage above the gate threshold voltage Vₜₕ the other IGBTs 3 present in the power semiconductor module 1 are turned on. This happens, since the gate terminal of the IGBT module 1, i.e. the control module contact 7, is floating and no gate current can flow through the gate path and therefore the voltage drop between gate and emitter of the damaged chip 3 is seen by all the other non-damaged chips 3. For the IGBT 3 to work properly with the gate floating, the IGBT 3 has to operate in an active region, because in saturation region V_{CE} would drop to a much lower value and consequently V_{GE} would decrease to a value lower than Vₜₕ. If a larger current has to be conducted, the collector-emitter voltage rises up to a value where V_{GE} reaches the right level to operate in the active region.

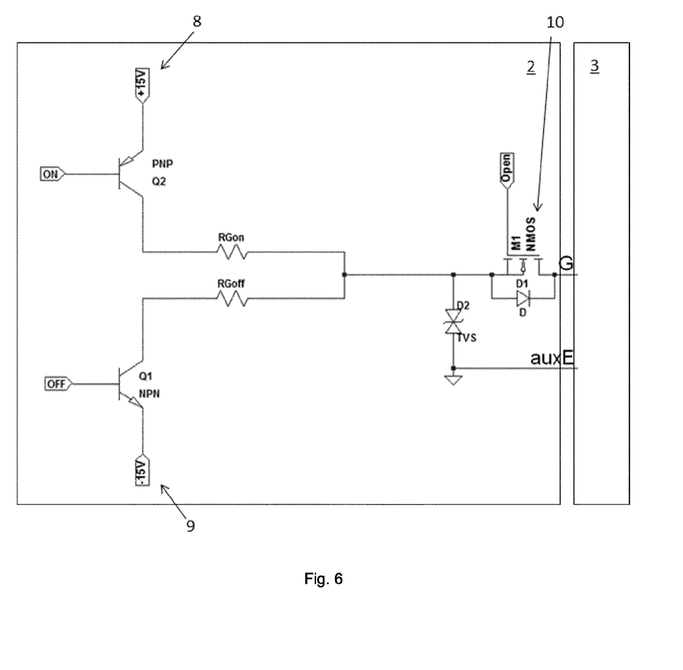

Fig. 6 shows further implementation details of said embodiment. The output stage of the gate driving device 2 comprises a conventional gate drive, which is amended as following: When the gate driving device 2 receives a turn-on signal from a turn-on signal source 8, PNP transistor Q2 is turned on and the gate of the IGBT 3, depicted with its gate and auxiliary emitter, is charged to 15 V through the turn-on gate resistor R_{Gon}. If a turn-off signal from a turn-off signal source 9 is received, NPN transistor Q1 is turned on and the gate of the IGBT 3 is discharged to -15 V through the turn-off gate resistor R_{Goff}. According to the invention, an additional state i.e. a disconnected state has been introduced such that the gate driving device 2 comprises a tri-state output: on, off and open. The open state i.e. disconnected state is introduced by adding a NMOS low power switching device 10, which disconnects the gate driving device 2 from the gate of the IGBT 3 in case the measured resistivity R_{GE}, R_{CE} and/or R_{CG} is below the threshold indicating a failure of the IGBT 3.

In normal operation NMOS M1 is on and the current can flow in both directions through the channel of the MOSFET 10. In case a failure is detected, M1 has to be turned off and its body diode allows for the gate voltage to rise above the voltage at the source terminal of M1. An additional supply referenced to the source terminal of M1 is preferably required in order to drive the low power switching device 10.

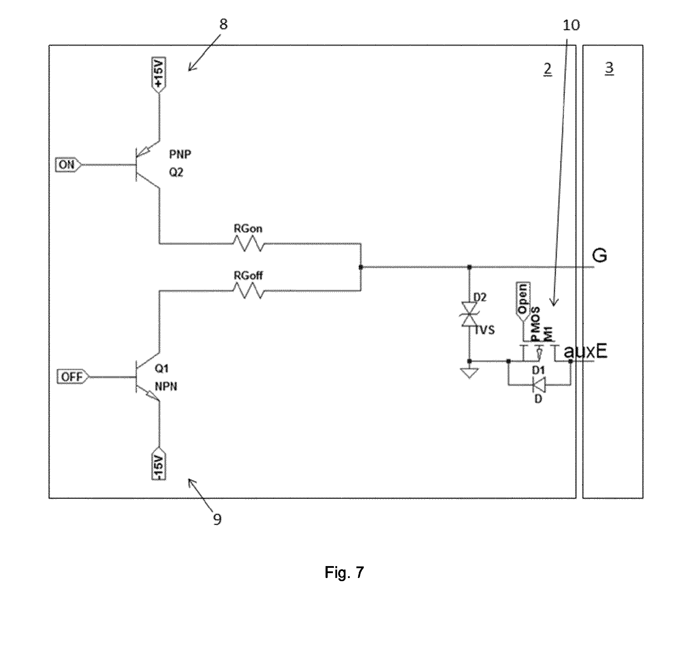

Fig. 7 shows another configuration, where a PMOS as low power switching device 10 is connected with the auxiliary emitter of the IGBT 3. With this arrangement the source terminal of the low power switching device 10 is connected to GND and the -15 V supply of the gate drive can be used to drive M1. For the low power switching device 10 preferably a NMOS/PMOS with low on-state resistance, e.g. 50-80 mΩ, which supports the peak gate current, should be chosen, and preferably has a voltage rating of typically 30 V.

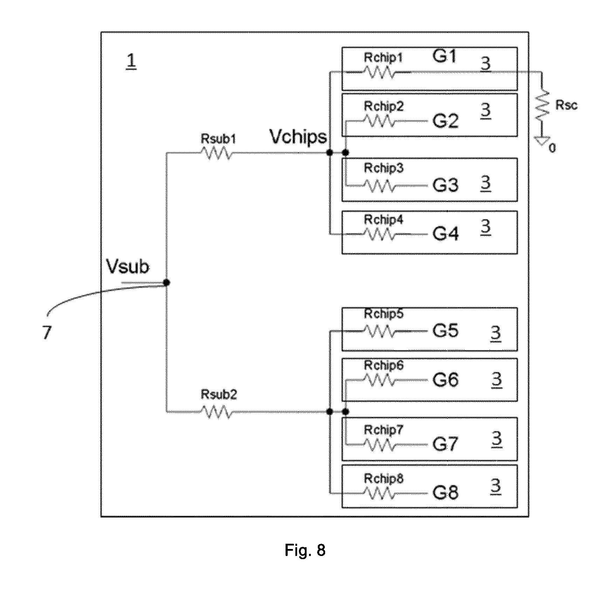

For the second alternative, the gate drive impedance is set to low, around 0 Ohm, such that the driving capability of the gate driver 2 is not limited by the short-circuit present between the gate 7 and auxiliary emitter 5 terminals of a damaged IGBT 3. Fig. 8 shows the schematic of the gate path of an IGBT module 1 that has two substrates with four IGBT chips 3 each and has a damaged chip 3, chip G1 at the top, in the first substrate. Each substrate has a substrate resistor R_{sub} that typically has a resistance in the order of 2 Ohm. Additionally, each IGBT chip 3 has its own gate resistor R_{chip}, which value changes with the manufacturer. Since IGBT chip G1 3 at the top is damaged, it has a short-circuit resistance R_{sc} between gate and emitter.

In order to turn-on the remaining good chips 3, voltage V_{sub} has to be higher than the gate threshold voltage Vₜₕ. The gate path to IGBT chip G1 3 at the top is shorted with a total resistance defined by the series connection of substrate resistor R_{sub1}, IGBT chip 3 gate resistor R_{chip1} and short-circuit resistance R_{sc}. Therefore a constant current I_{G} determined by the following equation has to be drawn in order to keep V_{sub} at certain level above Vₜₕ, i.e. **I_{G}** = V_{sub} / (R_{sub1} + R_{chip1} + R_{sc})

The IGBT chips 3 in the second, bottom substrate two will then see the voltage V_{sub}, while the good IGBT chips 3 in the upper substrate 1 will see a lower voltage V_{chips} as per following equation due to the constant current I_{G} flowing through substrate resistor R_{sub1}, i.e. V_{chips} = V_{sub}- (Vsub * R_{sub1}) / (Rsub1 + R_{chip1} + R_{sc})

A gate driver 2 for IGBTs 3 has turn-on and turn-off power sources 8, 9 connected to the output stage 7, and a an additional power source 11 with enough energy of e.g. 20-25V to maintain the gate voltage at the desired level while a constant current is being drawn has to be added and connected to the output stage 7. The control driving device 2 i.e. the gate drive 2 has then three states: turn-on, turn-off and overdriving. Additionally the gate-emitter short-circuit condition can be detected at gate drive level, such that said mode is directly activated when such a condition is present.

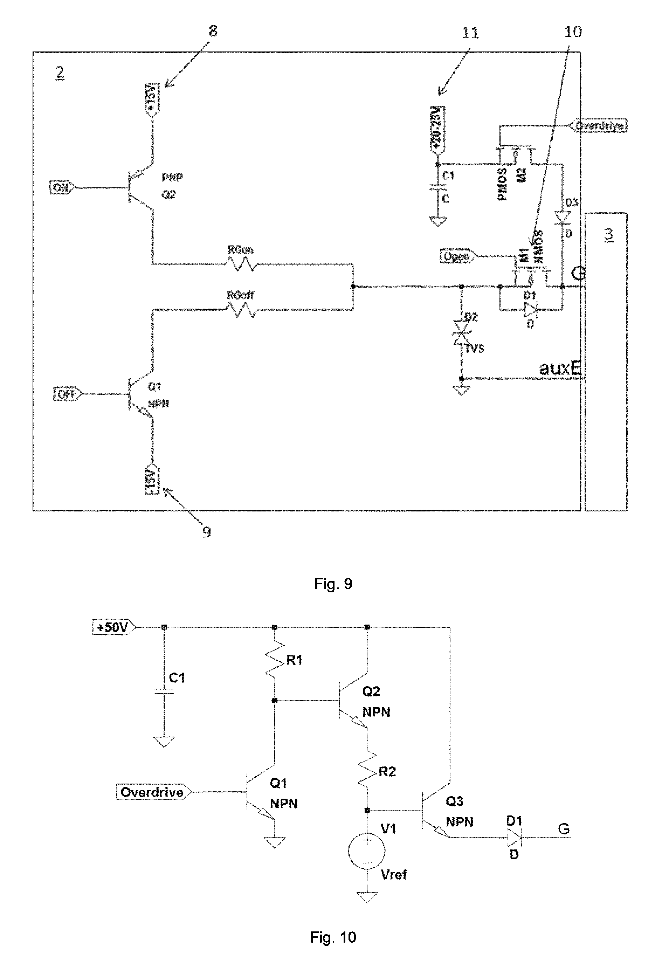

Fig. 9 shows exemplary implementations of said second method, in combination with before described first method. The method is activated by turning off NMOS/PMOS M1 and turning on PMOS M2. A diode can also be connected in series to M2 in order to allow the gate voltage to rise above the overdrive voltage. The choice of capacitor C1 depends on the energy required to keep the voltage within certain limits during the short-circuit duration. If the capacitor is initially charged at V_{ON}(0), a constant current Iₒᵤₜ is drawn from the GE short-circuit and constant current Iᵢₙ from the overdrive power supply charges C1, the capacitor voltage at time T would be V_{ON} (T)=V_{ON} (0) - 1/C * (Iₒᵤₜ-Iᵢₙ). Then if the difference between Iₒᵤₜ and Iᵢₙ is constant at I, the capacitance necessary to have at time T a drop of 5% from the initial voltage is C = (20*T*I) / (V_{ON} (0))

If time T is chosen to be 30 ms, which is the duration of the first positive half-cycle of the short-circuit current at 16.7 Hz, the maximum is reached. For the remaining cycles the gate drive 2 can also operate in first mode as the current level is considerably lower. It is preferred to charge the capacitor C to a higher voltage of e.g. 50 V in order to allow a higher voltage drop.

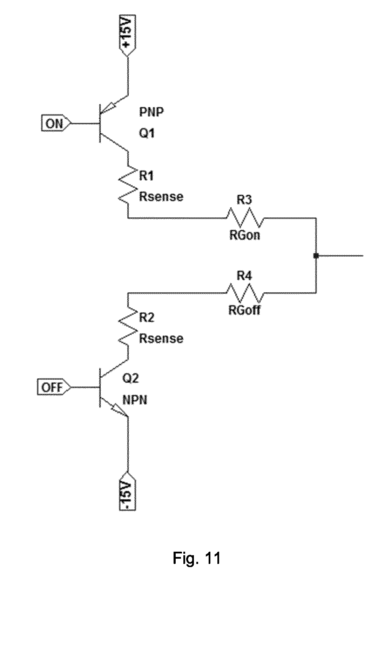

The circuit implementing this solution is shown in Fig. 10. The second method is activated by turning off NPN transistor Q1, then the gate voltage is regulated to V_{ref}. Also a diode is put in series to the Q3 in order to allow operation of the first method when the capacitor voltage drops below V_{ref} or a higher gate voltage is required. Triggering said methods can come from detection of a short-circuit directly at gate drive level. Conventional gate drives have current sensing resistors Rₛₑₙₛₑ on both turn-on and turn-off paths as shown in Fig. 11 which can be used to detect a short-circuit and therefore activate said methods.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

### Reference signs list

- S1, S2, S3, S4: IGBT power semiconductor device (prior art)
- D1, D2, D3, D4: Diode (prior art)
- 1: power semiconductor module
- 2: control driving device
- 3: power semiconductor device
- 4: first main module contact
- 5: first auxiliary module contact
- 6: second main module contact
- 7: control module contact
- 8: turn-on signal source
- 9: turn-off signal source
- 10: low power switching device
- 11: additional power source

## Claims

1. Power semiconductor arrangement, comprising
a power semiconductor module (1) and a control driving device (2), wherein the power semiconductor module (1) comprises a plurality of power semiconductor devices (3), a first main module contact (4), a first auxiliary contact (5), a second main module contact (6) and a control module contact (7),
each power semiconductor device (3) comprises a first main device contact, a first auxiliary device contact, a second main device contact and a control device contact, whereby all first main device contacts are connected to the first main module contact (4), all first auxiliary device contacts are connected to the first auxiliary module contact (5), all second main device contacts are connected to the second main module contact (6), and all control main device contacts are connected to the control module contact (7),
the control driving device (2) is configured for switching on the power semiconductor module (1) by applying a turn-on signal to the control module contact (7) and for switching off the power semiconductor module (1) by applying a turn-off signal to the control module contact (7), whereby the turn-on signal is greater than the turn-off signal,
the control driving device (2) is further configured for checking if a first resistivity between the first main module contact (4) and the control module contact (7), a second resistivity between the first main module contact (4) and the second main module contact (6) and/or a third resistivity between the control module contact (7) and the second main module contact (6) is below a threshold, and,
if the first, second and/or third resistivity is below the threshold, the control driving device (2) is configured for switching the control module contact (7) or the first auxiliary module contact (5) into a disconnected state and/or the control driving device (2) is configured for switching the control module contact (7) with an overdrive signal greater than the turn-on signal.

2. Power semiconductor arrangement according to the previous claim,
wherein the control driving device (2) comprises a low power switching device (10) configured for switching the control module contact (7) or the first auxiliary module contact (5) into the disconnected state.

3. Power semiconductor arrangement according to any of the previous
claims, wherein the power semiconductor device (3) is an IGBT, the first main contact of the power semiconductor device (3) is an emitter of the IGBT, the first auxiliary contact of the power semiconductor device (3) is an auxiliary emitter of the IGBT, the second main contact of the power semiconductor device (3) is a collector of the IGBT and the control contact of the power semiconductor device (3) is a gate of the IGBT.

4. Power semiconductor arrangement according to previous claim,
wherein the IGBT is provided as a reverse conducting IGBT or as a BIGT.

5. Power semiconductor arrangement according to any of the previous
claims, wherein the control driving device (2) comprises a turn-on signal source (8) configured for providing the turn-on signal and a turn-off signal source (9) configured for providing the turn-off signal,
the control driving device (2) is adapted for checking if a fourth resistivity between the turn-on signal source (8) and the control module contact (7) and/or a fifth resistivity between the turn-off signal source (9) and the control module contact (7) is below the threshold value, and,
if the fourth and/or fifth resistivity is below the threshold, the control driving device (2) is configured for switching the control module contact (7) or the first auxiliary module contact (5) into the disconnected state and/or the control driving device (2) is configured for switching the control module contact (7) with the overdrive signal.

6. Power semiconductor arrangement according to any of the previous
claims 2 to 4, wherein the low power switching device (10) is a MOSFET device.

7. Power semiconductor arrangement according to any of the previous
claims, wherein the turn-off signal is ≥ -15V and ≤ -5V, the turn-on signal is ≥ 5V and ≤ 15V and/or the overdrive signal is ≥ 20V and ≤ 30V.

8. Power semiconductor arrangement according to any of the previous
claims, wherein the power semiconductor module (1) comprises 4, 8, 16, 24, 32, 64, 128, 256, 512 or more power semiconductor devices (3).

9. Method for protecting a power semiconductor module (1) against
failures, wherein
the power semiconductor module (1) comprises a plurality of power semiconductor devices (3), a first main module contact (4), a first auxiliary module contact (5), a second main module contact (6) and a control module contact (7) configured for switching on the power semiconductor module (1) with a turn-on signal and for switching off the power semiconductor module (1) with a turn-off signal,
each power semiconductor device (3) comprises a first main device contact, a first auxiliary device contact, a second main device contact and a control device contact, whereby all first main device contacts are connected to the first main module contact (4), all first auxiliary device contacts are connected to the first auxiliary module contact (5), all second main device contacts are connected to the second main module contact (6), and all control main device contacts are connected to the control module contact (7), and
the method comprising the steps of:
checking if a first resistivity between the first main module contact (4) and the control module contact (7), a second resistivity between the first main module contact (4) and the second main module contact (6) and/or a third resistivity between the control module contact (7) and the second main module contact (6) is below a threshold, and
if the first, second and/or third resistivity is below the threshold, switching the control module contact (7) or the first auxiliary module contact (5) into a disconnected state and/or switching the control module contact (7) with an overdrive signal greater than the turn-on signal.

10. Method according to the previous claim, comprising a turn-on signal
source (8) configured for providing the turn-on signal and a turn-off signal source (9) configured for providing the turn-off signal, and
the method comprising the steps of:
checking if a fourth resistivity between the turn-on signal source (8) and the control module contact (7) and/or a fifth resistivity between the turn-off signal source (9) and the control module contact (7) is below the threshold value, and,
if the fourth and/or fifth resistivity is below the threshold, switching the control module contact (7) or the first auxiliary module contact (5) into the disconnected state and/or switching the control module contact (7) with the overdrive signal.

11. Method according to any of the previous claims, comprising a low
power switching device (10) configured for switching the control module contact (7) or the first auxiliary module contact (5) into the disconnected state.

12. Method according to the previous claim, wherein the low power
switching device (10) is a MOSFET device.

13. Method according to any of the previous claims, wherein the power
semiconductor device (3) is an IGBT, the first main contact of the power semiconductor device (3) is an emitter of the IGBT, the first auxiliary contact of the power semiconductor device (3) is an auxiliary emitter of the IGBT, the second main contact of the power semiconductor device (3) is a collector of the IGBT and the control contact of the power semiconductor device (3) is a gate of the IGBT.

14. Method according to any of the previous claims, wherein the turn-off
signal is ≥ -15V and ≤ -5V, the turn-on signal is ≥ 5V and ≤ 15V and/or the overdrive signal is ≥ 20V and ≤ 30V.

15. Method according to any of the previous claims, wherein the power
semiconductor module (1) comprises 4, 8, 16, 24, 32, 64, 128, 256, 512 or more power semiconductor devices (3).
